# EUROPEAN PATENT SPECIFICATION

(11) **EP 2 835 823 B1**
(45) Date of publication and mention of the grant of the patent: **11.09.2019**
(21) Application number: 13772507.3
(22) Date of filing: 01.04.2013
(51) Int. Cl.: H01L 23/36, H01L 23/373, H01L 25/07, H01L 25/18, H05K 7/20, H01L 25/16, H01L 21/48

(54) **POWER CONVERTER**
STROMWANDLER
CONVERTISSEUR DE PUISSANCE

(30) Priority: 02.04.2012 JP 2012083933
(43) Date of publication of application: 11.02.2015
(73) Proprietor: Fuji Electric Co., Ltd., Kawasaki-shi, Kanagawa 210-9530 (JP)
(72) Inventor: OKAMOTO, Kenji, Kawasaki-shi Kanagawa 210-9530 (JP); WATANABE, Akane, Kawasaki-shi Kanagawa 210-9530 (JP)
(74) Representative: Appelt, Christian W.
(86) International application number: PCT/JP2013/002253
(87) International publication number: WO 2013/150772

(56) References cited:
- JP-A- 2000 228 466
- JP-A- 2004 047 863
- JP-A- 2006 278 558
- JP-A- 2011 129 731
- JP-A- 2012 015 287
- US-A1- 2004 218 364
- US-B1- 6 362 964

## Description

### TECHNICAL FIELD

The present invention relates to a power converter using power semiconductor elements, such as an inverter, a servo controller, and a UPS.

### BACKGROUND ART

Power converters formed from power semiconductor elements and the like are used extensively in the consumer appliances such as household air conditioners and refrigerators, as well as the industrial equipment such as inverters and servo controllers.

The power semiconductor elements are placed on a wiring board such as a metal base substrate or a ceramic substrate in view of the electric power consumption. One or more circuit elements such as power semiconductor elements are placed on the wiring board, to which a plastic case frame is adhered, which is then sealed with silicone gel or epoxy resin. As a result, a power semiconductor module is obtained.

There is also a full-mode power semiconductor module which is configured by a transfer molding technique for the purpose of cutting the manufacturing cost (see JP H9-139461 A, for example).

A power converter normally uses the aforementioned power semiconductor module as a main circuit and is configured by this main circuit, other power supply circuits, and control circuits. The power supply circuits and the control circuits are configured by ICs, LSIs, resistors, capacitors, reactors and other components and are normally mounted on printed wiring boards.

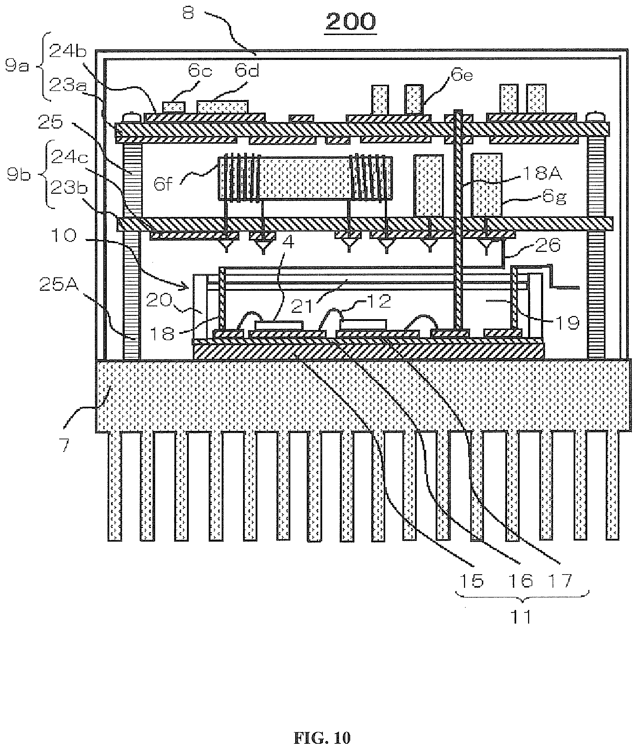

Fig. 10 shows an example of the structure of a conventional power converter. A power semiconductor module 10 is placed on a heat sink 7, with a thermal grease placed therebetween for the purpose of enhancing the heat dissipation performance. A printed wiring boards 9a and 9b with electronic circuit components are disposed thereon and joined together with pins or the like. The resultant structure is then covered with a case 8, completing a power converter 200.

In Fig. 10, the power semiconductor module 10 has an insulting substrate 11, connection lead terminals 18, 18A, insulating resin 19, a power semiconductor element 4, an aluminum wire 12, a case main body 20, and a lid 21. The insulating substrate 11 is obtained by forming an insulating layer 16 on the surface of a metal base 15 and forming a circuit pattern 17 on the surface of the insulating layer 16. The metal base 15 is, for example, an aluminum plate, an aluminum alloy plate, a copper plate, or a copper alloy plate. The insulating layer 16 is formed by, for example, solidifying epoxy resin containing an inorganic filler such as silicon oxide, aluminum oxide, or aluminum nitride. The circuit pattern 17 is formed from, for example, a thin copper film.

The case main body 20 made of resin (epoxy, PPS, PBT, etc.) is fixed onto the insulating substrate 11 to form a storage space. A back electrode of the power semiconductor element 4 and the connection lead terminals 18, 18A are soldered (connected, fixed) to the circuit pattern 17 of the insulating substrate 11, and a surface electrode of the power semiconductor element 4 and the circuit pattern 17 are connected to each other by the aluminum wire 12. The storage space formed by the case main body 20 is filled with the insulating resin 19 of high thermal conductivity such as silicone gel or epoxy resin, to seal the power circuits. The opening portion of the case main body 20 is covered with the lid 21 made of the same type of resin as the case main body 20, wherein the connection lead terminals 18, 18A pass through the lid 21.

The printed wiring boards 9a, 9b have circuit patterns 24b, 24c made of, for example, copper foil which are formed on electrically insulating substrate main bodies 23a, 23b configured by, for example, glass epoxy (glass fiber-reinforced epoxy resin). The printed wiring board 9a has surface-mounted electronic circuit components 6c, 6d, 6e soldered thereto, while the printed wiring board 9b has hole-insertion type electronic circuit components 6f, 6g soldered thereto. The printed wiring boards 9a, 9b are fixedly supported on the heat sink 7 by supporting columns 25, 25A.

The power semiconductor module 10 is connected to the printed wiring boards 9a, 9b disposed thereon, by the connection lead terminals 18, 18A. In Fig. 10, the connection lead terminal 18 is connected to the circuit pattern 24c of the printed wiring board 9b by wiring 26, while the connection lead terminal 18A is connected directly to the circuit pattern 24b of the printed wiring board 9a.

Document US 6,362,964 B1 discloses a power assembly, in which an insulated metal substrate supports power semiconductor devices and is mounted directly on a heatsink, which supports a circuit board that is mounted above and spaced from the top side of the insulated metal substrate.

### DISCLOSURE OF THE INVENTION

However, there is a certain level of thermal resistance in the power semiconductor module due to the presence of many materials on the heat sink, including the power semiconductor elements mounted on the insulating substrates. For this reason, the conventional power converter is not always able to efficiently release the heat of the power semiconductors due to its insufficient cooling characteristics.

The lower the thermal resistance, the lower the temperature of the power semiconductor elements can be when the power converter is running. Consequently, the power semiconductor elements can be formed into small chips, resulting in a cost reduction.

In addition, because the power semiconductor module is configured as a single product, a certain capacity needs to be provided in the power converter in order to dispose the power semiconductor module therein. This interferes not only with downsizing of the power converter but also with reduction of the cost of the power converter.

The present invention was contrived in view of the foregoing problems, and an object thereof is to provide an excellent power converter that is not only excellent in heat dissipation but also small and meets the demands for cost reduction.

In order to achieve this object, the present invention provides a power converter according to claim 1.

According to the invention described above, because the metal block of high heat capacity and excellent heat dissipation performance comes into direct contact with the cooling heat sink with the ceramic heat dissipation insulating layer therebetween, the thermal resistance at the lower part of the first circuit element configured by a power semiconductor element can be reduced, improving the heat dissipation performance. Therefore, a smaller power semiconductor chip with low cost can be employed as the power semiconductor element.

Furthermore, the power semiconductor unit in which the first circuit element configured by a power semiconductor element is mounted on the upper surface of the metal block and the printed wiring board unit in which the second circuit element is mounted on the printed wiring board are integrated into the power conversion circuit assembly by fitting the metal block to the hole of the printed wiring board. Such a configuration eliminates the need to store just the main circuit portion configured by power semiconductor elements into an independent case as in the conventional power semiconductor module. Therefore, the volume of the power converter can be reduced because it is not necessary to connect the power semiconductor module to the printed wiring board equipped with the other electronic circuit components via the connection lead terminals provided in the case.

Not requiring a dedicated power semiconductor module can lead to a reduction in cost of the power converter.

In the power converter described above, the hole can be an opening of a through-hole portion configured by a conductor layer. The metal block can be fixed to the through-hole portion by soldering. The heat dissipation insulating layer on the upper surface of the cooling heat sink can be configured to include a region abutting against the lower surface of the metal block and a region abutting against a land surface of the through-hole portion.

In addition, a conductor pattern portion can be formed on a lower surface side of the printed wiring board, and the heat dissipation insulating layer on the upper surface of the cooling heat sink can be configured to include a region abutting against the lower surface of the metal block, a region abutting against a land surface of the through-hole portion, and a region abutting against a pattern surface of the conductor pattern portion.

According to this information, in addition to the lower surface of the metal block and the land surface of the through-hole portion on the lower surface side of the printed wiring board, the pattern surface of the conductor pattern portion on the lower surface side of the printed wiring board can be brought into abutment against the upper surface of the cooling heat sink with the heat dissipation insulating layer therebetween. Such a configuration can make the mechanical support structure of the power conversion circuit assembly more stable on the cooling heat sink.

Moreover, the power semiconductor unit has a relay electrode insulating layer formed by directly depositing a ceramic material on a part of the upper surface of the metal block, and a relay electrode formed by depositing a metallic material on an upper surface of the relay electrode insulating layer. A bonding wire or a lead frame from the first circuit element can be joined to the relay electrode, and the relay electrode and a circuit pattern portion on the upper surface side of the printed wiring board can be connected to each other.

According to this configuration, because a bonding wire or a lead frame from the first circuit element is joined to the relay electrode, and the relay electrode is connected to the circuit pattern portion on the upper surface side of the printed wiring board, the first circuit element and the circuit pattern portion on the upper surface side of the printed wiring board are connected to each other by the relay electrode.

Accordingly, when heat is generated during operation of the first circuit element configured by a power semiconductor element, the heat is transmitted along the bonding wire or the lead frame extending from the first circuit element, to the metal block of high heat capacity and excellent heat dissipation performance mainly via the relay electrode and the relay electrode insulating layer made of ceramic, sufficiently minimizing the amount of heat transmitted to the circuit pattern portion on the upper surface side of the printed wiring board. Therefore, the heat dissipation performance of the power converter can further be improved.

Also, the relay electrode can be formed by thermally spraying copper particles as the metallic material.

The relay electrode and the circuit pattern portion on the upper surface side of the printed wiring board can be connected to each other by the bonding wire or the lead frame.

The heat dissipation insulating layer and/or the relay electrode insulating layer can have a thermal conductivity of 1 to 200 W/m·K and a thickness of 10 to 500 µm.

The heat dissipation insulating layer and/or the relay electrode insulating layer can be configured by at least one type selected from a group of fillers consisting of silicon oxide, aluminum oxide, silicon nitride, aluminum nitride, and boron nitride. In addition, the heat dissipation insulating layer and/or the relay electrode insulating layer can be formed by plasma spray deposition of ceramic fine particles of at least one type selected from the group of fillers. The heat dissipation insulating layer and/or the relay electrode insulating layer can be formed by aerosol deposition of ceramic fine particles of at least one type selected from the group of fillers.

The present invention can provide an excellent power converter that is not only excellent in heat dissipation but also small and meets the demands for cost reduction.

### BRIEF DESCRIPTION OF THE DRAWINGS

Fig. 1 is a cross-sectional diagram showing the configuration of a power converter;
Fig. 2 is a cross-sectional diagram showing a method for manufacturing the power converter;
Fig. 3 is a cross-sectional diagram showing the method for manufacturing the power converter;
Fig. 4 is a cross-sectional diagram showing the configuration of a power converter according to the present invention;
Fig. 5 is a diagram schematically showing a flow of heat in the power converter according to the present invention;
Fig. 6 is a cross-sectional diagram showing a method for manufacturing the power converter according to the present invention;
Fig. 7 is a cross-sectional diagram showing the method for manufacturing the power converter according to the present invention;
Fig. 8 is a cross-sectional diagram showing the method for manufacturing the power converter according to the present invention;
Fig. 9 is a cross-sectional diagram showing a different configuration example of the power converter according to the present invention; and
Fig. 10 is a cross-sectional diagram showing an example of the structure of a conventional power converter.

### BEST MODE FOR CARRYING OUT THE INVENTION

The embodiments of the present invention are described hereinafter in detail with reference to the drawings. It should be noted that the present invention is not limited to the following embodiments and can be implemented with suitable modification without changing the gist thereof. Moreover, in the following description, the same reference numerals are applied to the same parts or elements throughout the drawings unless otherwise designated.

### <First Embodiment>

The first embodiment does not fall under the claimed invention and is given for illustrative purposes only. The first embodiment is, however, helpful to understand the invention.

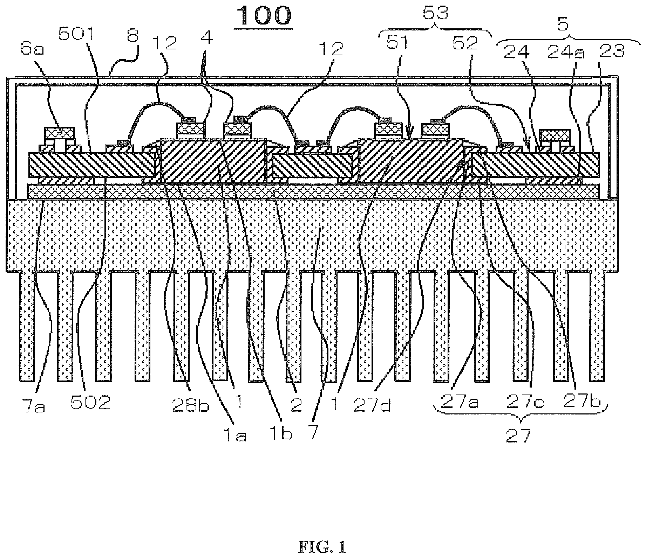

Fig. 1 is a cross-sectional diagram showing the configuration of a power converter according to a first embodiment. In Fig. 1, a power semiconductor unit 51 is configured by mounting a power semiconductor element 4 such as an IGBT (Insulated Gate Bipolar Transistor) on an upper surface 1b of a metal block 1 having the upper surface 1b and a lower surface 1a. A printed wiring board unit 52 is configured by mounting an electronic circuit component 6a on a printed wiring board 5 on which is formed a through-hole portion 27 with a hole 27d for fitting the metal block 1. The power semiconductor unit 51 and the printed wiring board unit 52 are integrated into a power conversion circuit assembly 53 by fitting the metal block 1 to the hole 27d. Note that the upper surface 1b and the lower surface 1a of the metal block 1 are referred to as "front surface 1b" and "rear surface 1a" hereinafter, respectively.

The printed wiring board 5 has circuit patterns 24 and 24a made of, for example, copper foil which are formed on an upper surface 501 and a lower surface 502 of an electrically insulating substrate main body 23 configured by, for example, glass epoxy (glass fiber-reinforced epoxy resin). The substrate main body 23 is provided with a through-hole. A conductor layer made of, for example, copper foil is integrally formed on an inner circumferential surface of this through-hole and rim portions of the through-hole on the upper surface 501 and the lower surface 502 of the substrate main body 23, thereby configuring a conductor portion of the through-hole portion 27. The conductor layer part provided on the inner circumferential surface of the through-hole is configured as a through conductor portion 27a, and the conductor layer parts provided on the rim portions of the through-hole at the upper surface 501 and the lower surface 502 of the substrate main body 23 are configured respectively as an upper surface land conductor portion 27b and a lower surface land conductor portion 27c. The through conductor portion 27a has the hole 27d conformed to, for example, the square or rectangular shape of the metal block 1. In the following description, the upper surface 501 and the lower surface 502 of the substrate main body 23 are referred to as "front surface 501" and "rear surface 502," respectively. The upper surface 501 of the substrate main body 23 is a component mount surface.

A ceramic material is formed directly on an upper surface 7a of the cooling heat sink 7 as a heat dissipation insulating layer 2.

The power conversion circuit assembly 53 is attached to the cooling heat sink 7 in such a manner that the lower surface 1a of the metal block 1 abuts against the upper surface 7a of the cooling heat sink 7 with the heat dissipation insulating layer 2 therebetween. Furthermore, a case 8 for covering the power conversion circuit assembly 53 from above is also attached to the cooling heat sink 7, configuring a power converter 100.

In the power converter 100, the power semiconductor element 4 mounted on the upper surface 1b of the metal block 1 configures a main circuit, and the electronic circuit component 6a mounted on the printed wiring board 5 configures another power supply circuit or control circuit. Various components such as an IC, an LSI, a resistor, a capacitor, and a reactor can be used as the electronic circuit component 6a.

In the power converter 100, the power semiconductor element 4 and the circuit pattern 24 of the printed wiring board 5 are connected to each other by an aluminum wire 12 to form a circuit, as shown in Fig. 1.

In the power converter 100 as described above, the power semiconductor unit 51 configuring by mounting the power semiconductor element 4 on the upper surface 1b of the metal block 1 and the printed wiring board unit 52 configured by mounting the electronic circuit component 6a on the printed wiring board 5, are integrated by fitting the metal block 1 to the hole 27d of the printed wiring board 5. Such a configuration eliminates the need to store just the main circuit portion configured by power semiconductor elements into an independent case as in the conventional power semiconductor module. Therefore, the volume of the power converter can be made smaller than that of the conventional power semiconductor module because the power semiconductor element 4 and the circuit pattern 24 of the printed wiring board 5 can directly be connected to each other by the aluminum wire 12.

In the power converter 100, the metal block 1 is configured with a metallic material of high electric conductivity and thermal conductivity, such as copper, into a thickness of approximately 1.0 to 5.0 mm to obtain high heat capacity and excellent heat dissipation performance.

Also in the power converter 100, the heat dissipation insulating layer 2 on the upper surface 7a of the cooling heat sink 7 is made of, for example, aluminum oxide, silicon nitride, aluminum nitride, boron nitride, or other ceramic materials of excellent thermal conductivity, as will be described later. Note that the heat dissipation insulating layer 2 preferably has a thermal conductivity of 1 to 200 W/m·K and a thickness of 10 to 500 µm.

In the power converter 100 configured as described above, the lower surface 1a of the metal block 1 of high heat capacity and excellent heat dissipation performance, on which the power semiconductor element 4 is mounted, is brought into direct contact with the cooling heat sink 7, with the heat dissipation insulating layer 2 therebetween which is made of a ceramic material of excellent thermal conductivity. Therefore, the thermal resistance at the lower part of the power semiconductor element 4 can sufficiently be reduced, providing excellent heat dissipation performance.

Note that Fig. 1 shows the configuration example in which two metal blocks 1 are integrated with the printed wiring boards 5 respectively by fitting the metal blocks 1 to the holes 27d of two through-hole portions 27 on the respectively printed wiring boards 5; however, the number of metal blocks 1 to be integrated with the printed wiring boards 5 may be one, three or more. Fig. 1 also shows a configuration example in which two power semiconductor elements 4 are mounted on each metal block 1; however, the number of power semiconductor elements 4 to be mounted on a metal block 1 may be one, three or more.

The metallic material for forming each metal block 1 is not limited to copper; thus, for example, copper alloy, aluminum, aluminum alloy and the like can also be employed.

Also, copper, copper alloy, aluminum, aluminum alloy or the like, for example, is applicable as the metallic material for forming the cooling heat sink 7.

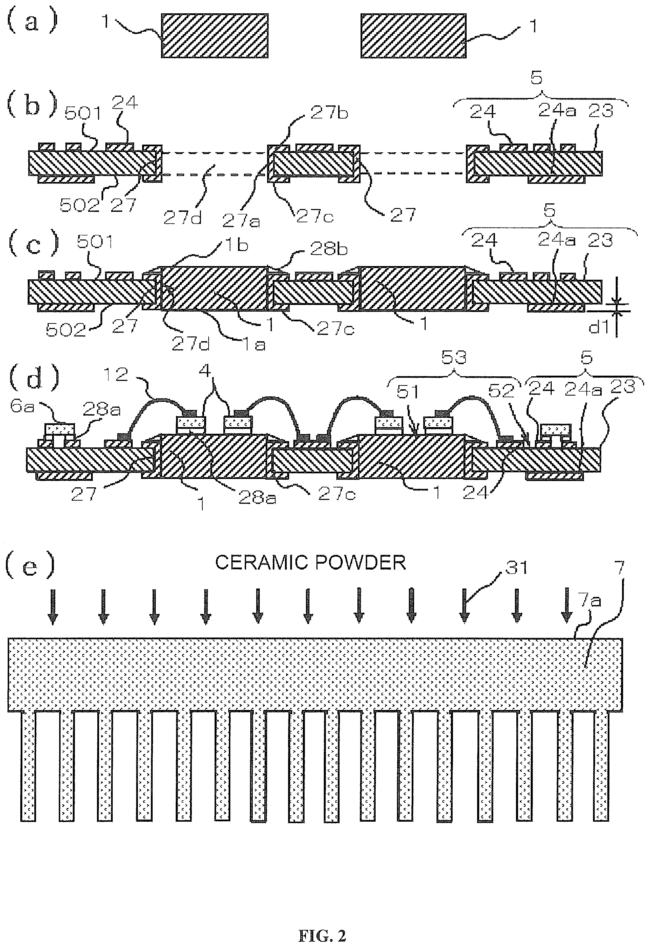

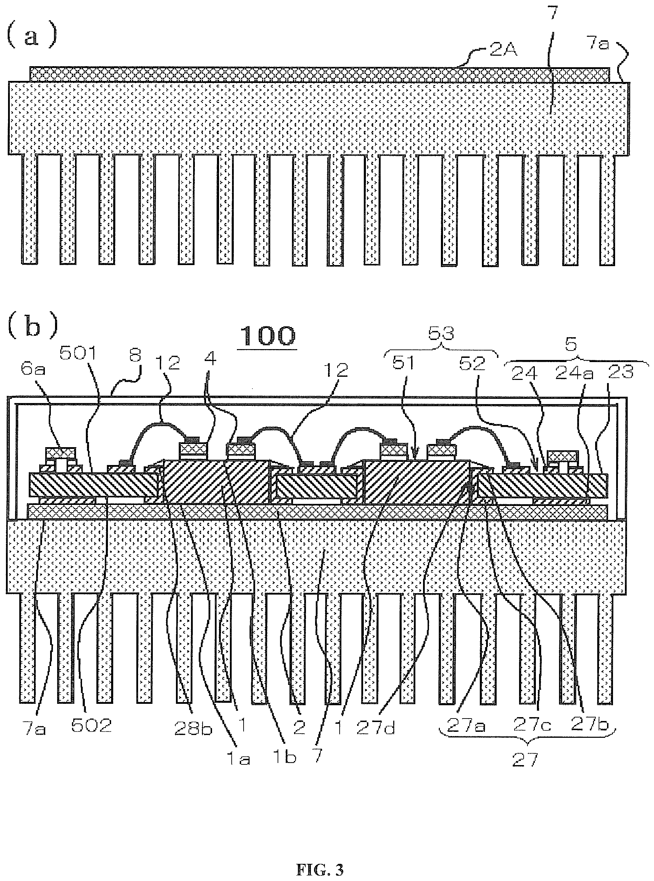

Next, a method for manufacturing the power converter 100 is described with reference to Figs. 2 and 3. Figs. 2 and 3 are cross-sectional diagrams each showing the method for manufacturing the power converter according to the first embodiment.

First of all, a copper plate with a thickness of approximately 1.0 to 5.0 mm is stamped into a square or a rectangle to create a metal block 1 (Fig. 2(a)).

Next, the circuit patterns 24 and 24a made of, for example, copper foil, are formed respectively on the upper surface 501 and the lower surface 502 of the electrically insulating substrate main body 23 configured by, for example, glass epoxy, and the through-hole portion 27 having the through conductor portion 27a, the upper surface land conductor portion 27b, and the lower surface land conductor portion 27c that are made of, for example, copper foil, is formed on the substrate main body 23. As a result, a printed wiring board 5 is obtained (Fig. 2(b)). The hole 27d of the through-hole portion 27 is shaped to be able to accommodate the metal block 1 therein.

Next, the metal block 1 is inserted into the hole 27d of the through-hole portion 27 of the printed wiring board 5 and fixed to the printed wiring board 5 by soldering 28b (Fig. 2(c)). In so doing, an adhesive or the like may be employed together with the soldering in order to enhance the joining force between the printed wiring board 5 and the metal block 1.

Here, the position of the metal block 1 in the thickness direction relative to the printed wiring board 5 is preferably adjusted such that a lower surface 1a of the metal block 1 is flush with a land surface of the lower surface land conductor portion 27c of the through-hole portion 27 of the printed wiring board 5 and a pattern surface of the circuit pattern 24a on the lower surface 502 of the printed wiring board 5. In order to do so, the lower surface land conductor portion 27c and the circuit pattern 24a in the printed wiring board 5 are formed into the same thickness d1 (see Fig. 2(c)), and the distance of protrusion of the lower surface 1a of the metal block 1 in relation to the lower surface 502 of the substrate main body 23 of the printed wiring board 5 is also set at d1. This configuration can allow the lower surface 1a of the metal block 1, the land surface of the lower surface land conductor portion 27c, and the pattern surface of the circuit pattern 24a to evenly abut against the heat dissipation insulating layer 2 of the cooling heat sink 7 when executing the subsequent step shown in Fig. 3(b) where the power conversion circuit unit 53 obtained by integrating the power semiconductor unit 51 and the printed wiring board unit 52 is placed on the cooling heat sink 7. Therefore, the mechanical support structure of the power conversion circuit unit 53 can be made stabilized. The foregoing configuration can also allow the lower surface 1a of the metal block 1 to abut in close contact with the heat dissipation insulating layer 2 of the cooling heat sink 7 because the land surface of the lower surface land conductor portion 27c and the pattern surface of the circuit pattern 24a do not protrude further than the lower surface 1a of the metal block 1 toward the cooling heat sink 7. Consequently, favorable thermal conductivity can be ensured between the lower surface 1a of the metal block 1 and the heat dissipation insulating layer 2 of the cooling heat sink 7.

Next, the power semiconductor element 4 is mounted and bonded onto the metal block 1 by soldering 28a, and various electronic circuit components 6a are mounted and bonded onto the printed wiring board 5 by soldering 28a (Fig. 2(d)). Normally these parts are mounted using cream solder in a reflow furnace. For example, a high-temperature solder material consisting of SnPbAg or a lead-free solder material consisting of SnAgCu is used. The soldering temperature is set based on the solder melting point. If there is a void remaining in the solder layer 28a that joins the power semiconductor element 4 and the metal block 1 together, it leads to an increase in the thermal resistance, resulting in an inability to efficiently release the heat generated from the power semiconductor element 4. For the purpose of preventing the generation of voids, vacuum drawing is executed at 1.3 kPa (10 Torr) or less while the solder is melting.

Furthermore, the power semiconductor element 4 and the circuit pattern 24 of the printed wiring board 5 are connected to each other by an aluminum wire 12 to form a circuit. The aluminum wire 12 is an Al wire with a wire diameter of 125 to 500 µm and is used for ultrasonically joining the power semiconductor element 4 and the circuit pattern 24 together. A lead frame or a ribbon-shaped aluminum wire may also be used for joining these parts.

Next, the heat dissipation insulating layer 2 is formed on the upper surface 7a of the cooling heat sink 7 by depositing ceramic powder 31 on the upper surface 7a by means of a thermal spraying method or an aerosol deposition method (Figs. 2(e) to 3(a)).

In the case where, for example, a plasma spraying method is used as the thermal spraying method to form the heat dissipation insulating layer 2 on the upper surface 7a of the cooling heat sink 7, one or more types of ceramic powder consisting of silicon oxide, aluminum oxide, silicon nitride, aluminum nitride, and boron nitride are used. The powder is sprayed onto the upper surface 7a of the cooling heat sink 7 in an atmosphere under atmospheric pressure or reduced pressure, to deposit the heat dissipation insulating layer 2 thereon. The thickness of the heat dissipation insulating layer 2 can be adjusted by controlling the thermal spraying time. The thickness of the heat dissipation insulating layer 2 is preferably 10 to 500 µm.

The heat dissipation insulating layer 2 is formed in such a manner as to cover the entire exposed surface of the upper surface 7a of the cooling heat sink 7. Note that the heat dissipation insulating layer 2 may be formed partially on the upper surface 7a of the cooling heat sink 7 as long as the metal block 1 and the printed wiring board 5 are electrically insulated from the cooling heat sink 7, the metal block 1 and the printed wiring board 5 being attached in the subsequent step. In the case where the circuit pattern 24a is formed on the lower surface 502 of the printed wiring board 5, the heat dissipation insulating layer 2 on the upper surface 7a of the cooling heat sink 7 is formed so as to include a region abutting against the lower surface 1a of the metal block 1, a region abutting against the land surface of the lower surface land conductor portion 27c, and a region abutting against the pattern surface of the circuit pattern 24a.

The heat dissipation insulating layer 2 formed in this manner has such insulation characteristics as a thickness of, for example, 200 µm and an AC breakdown voltage of 5 kV or higher, and can also be used in a power device having a withstand voltage rating of 1200 V.

Next is described how the heat dissipation insulating layer 2 is deposited on the upper surface 7a of the cooling heat sink 7 by means of an aerosol deposition method. The aerosol deposition method is a technology for mixing fine particle or ultrafine particle raw material with gas into aerosol and then spraying the aerosol to form a film on a substrate through a nozzle. Helium or air is used as the gas. The device used in this method can be configured by an aerosolization chamber and a film deposition chamber which are not shown. The pressure inside the film deposition chamber is reduced to approximately 50 Pa to 1 kPa by a vacuum pump. The fine particles or ultrafine particles as the raw material are stirred/mixed dry with the gas of the aerosolization chamber into aerosol, which is then transferred to the film deposition chamber by a flow of gas generated by the difference in pressure between the both chambers. The aerosol accelerates as passing through a slit-shaped nozzle and is injected onto the upper surface 7a of the cooling heat sink 7 on which a film is to be formed. Ceramic powder that is mechanically pulverized into 0.1 to 2 µm is used as the raw material fine particles. The ultrafine particles transferred by the gas is passed through a nozzle with a small opening in the decompressed chamber and thereby accelerates up to several hundreds of meters per second. Because the film deposition speed or the density of the film product depends largely on the grain diameter, the aggregation state, the state of dryness and the like of the ceramic fine particles, an aggregated particle crusher or classifier is used between the aerosolization chamber and the film deposition chamber.

In order to form the heat dissipation insulating layer 2 as a film, ceramic fine particles with a grain diameter of 0.1 to 2 µm are sprayed onto the substrate at high speed. At this moment, the ceramics fine particles are pulverized into fine crystal particles of approximately 10 to 30 nm by the collision energy resulting from the foregoing spraying process. Consequently, a newly formed surface is created, the front surface of which is then activated, allowing the particles to bond to each other. As a result, a ceramic film with a dense nanocrystalline structure is created. The ceramic film can also be formed at normal temperature without having to have to increase the temperature in particular.

It is preferred that aluminum oxide, silicon nitride, aluminum nitride, or boron nitride with a grain diameter of approximately 0.1 to 2 µm be used as the aerosol-deposited fine particles. The fine particles are sprayed for a predetermined period of time to form the heat dissipation insulating layer 2 of required thickness, as shown in Figs. 2(e) to 3(a).

A product obtained by forming an aluminum oxide film on a silicon nitride filler, an aluminum nitride filler, or a boron nitride filler, or a product obtained by forming a silicon oxide film on a silicon nitride filler, an aluminum nitride filler, or a boron nitride filler, is also applicable as the fine particles. The heat dissipation insulating layer 2 with a combination of two or more types of ceramic materials can be formed using these fine particles.

The thickness of the heat dissipation insulating layer 2 is preferably 10 to 500 µm as with the one obtained by the thermal spraying method. The heat dissipation insulating layer 2 formed in the manner described above has such insulation characteristics as a thickness of, for example, 200 µm and an AC breakdown voltage of 5 kV or higher, and can also be used in a power device having a withstand voltage rating of 1200 V.

Finally, a power conversion circuit unit 53 in which the power semiconductor unit 51 and the printed wiring board unit 52 are integrated with each other is placed on the cooling heat sink 7 having the heat dissipation insulating layer 2, with a thermal grease therebetween. The resultant structure is then covered with the case 8, completing the power converter 100 (Fig. 3(b)).

As described above, the ceramic insulating layer formed by the aerosol deposition method or the plasma spraying method is employed as the heat dissipation insulating layer 2 formed on the upper surface 7a of the cooling heat sink 7 in the power converter of the present embodiment. Such a configuration brings about the following advantages:

### (1) Improvement in dielectric voltage

The aerosol deposition method is capable of film deposition under room temperature (normal temperature) and collides the ceramic fine particles of submicron order with the substrate at sonic speeds, allowing the ceramic fine particles to bond to each other on the exposed, active newly formed surface. The same is true for the plasma spraying method. Either method can form a ceramic fine particle layer which is an extremely dense electrical insulating film. In addition, due to the absence of holes (voids) in the film, the breakdown voltage per unit length of the film is improved approximately 10 times more than a ceramic plate formed by a conventional sintering process.

### (2) Decrease in thermal resistance

Thermal conductivity is equal to a bulk conductivity. Aluminum oxide (Al₂O₃), for example, secures a thermal conductivity of approximately 20 W/m·K, aluminum nitride (AlN) approximately 160 to 180 W/m·K, and silicon nitride (Si₃N₄) approximately 80 W/m·K. The insulating layer 2 can be formed thin in order to improve the breakdown voltage per unit length, resulting in a reduction of the total thermal resistance.

Owing to the foregoing points, both high insulation and low thermal resistance can be realized.

In the power converter of the present embodiment, the metal block 1 having the power semiconductor element 4 mounted on its upper surface 1b (front surface) has its lower surface 1a (rear surface) coming into direct contact with the cooling heat sink 7, with the heat dissipation insulating layer 2 made of a ceramic material of excellent thermal conductivity therebetween, as described above. Such a power converter, therefore, has a sufficiently low thermal resistance at a lower part of the power semiconductor element 4 and excellent heat dissipation performance.

Note that the foregoing embodiment describes mainly the configuration in which the circuit pattern 24a is formed on the lower surface 502 (rear surface) side of the printed wiring board 5 as shown in Fig. 1; however, the present invention is not limited to this configuration and can be applied to a configuration where the circuit pattern 24a is not formed on the lower surface 502 (rear surface) side of the printed wiring board 5. In this case, the heat dissipation insulating layer 2 on the upper surface 7a of the cooling heat sink 7 may be formed so as to include the region abutting against the lower surface 1a (rear surface) of the metal block 1 and the region abutting against the land surface of the lower surface land conductor portion 27c.

### <Second Embodiment>

The second embodiment is an illustration of the claimed invention.

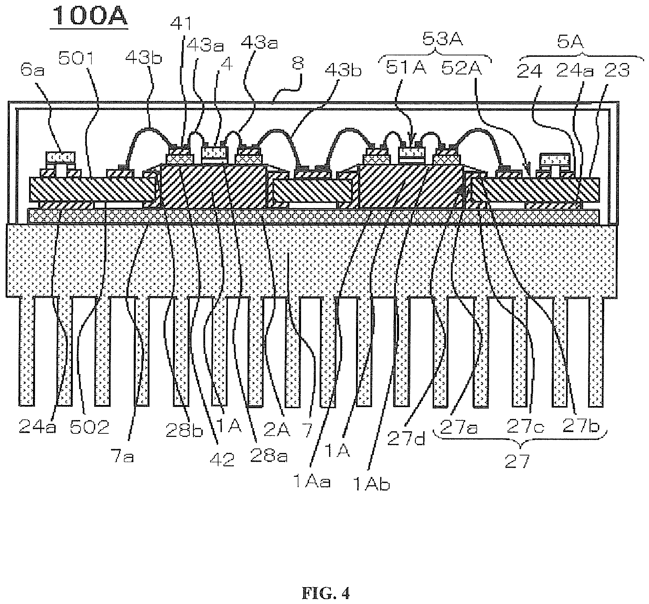

Fig. 4 is a cross-sectional diagram showing the configuration of a power converter according to a second embodiment of the present invention.

The power converter according to the second embodiment has in particular, in the power converter according to the first embodiment, a relay electrode insulating layer that is formed by directly depositing a ceramic material on a part of an upper surface of the metal block having the upper surface and a lower surface, and a relay electrode that is formed by depositing a metallic material on an upper surface of the relay electrode insulating layer, wherein a bonding wire extending from the power semiconductor element on the upper surface of the metal block is bonded to the relay electrode, and the relay electrode and the circuit pattern of the printed wiring board are connected to each other by the bonding wire. The rest of the features of the power converter according to the second embodiment are the same as those of the power converter according to the first embodiment.

In a power converter 100A shown in Fig. 4, a power semiconductor unit 51A has a metal block 1A with an upper surface 1Ab and a lower surface 1Aa, a relay electrode insulating layer 42 formed on a part of the upper surface 1Ab of the metal block 1A, a relay electrode 41 formed on an upper surface of the relay electrode insulating layer 42, and a power semiconductor element 4 bonded to the upper surface 1Ab of the metal block 1A by soldering 28a, wherein a bonding wire 43a extending from the power semiconductor element 4 is bonded to the relay electrode 41. Furthermore, the relay electrode 41 on the power semiconductor unit 51A and the circuit pattern 24 on the upper surface 501 of the printed wiring board 5A are connected to each other by a bonding wire 43b. Note in Fig. 4 that, for convenience of explanation, reference numeral 43a is denoted the bonding wire that connects the power semiconductor element 4 and the relay electrode 41 to each other, and reference numeral 43b the bonding wire that connects the relay electrode 41 and the circuit pattern 24 on the upper surface 501 of the printed wiring board 5A to each other. Note that the upper surface 1Ab and the lower surface 1Aa of the metal block 1A are referred to as "front surface 1Ab" and "rear surface 1Aa," respectively, in the following description.

In the power converter 100A as well, the power semiconductor unit 51A and a printed wiring board unit 52A are integrated with each other into a power conversion circuit assembly 53A, wherein the configuration of the printed wiring board unit 52A in which an electronic circuit component 6a is mounted on the printed wiring board 5A is the same as that of the printed wiring board unit 52 of the power converter 100 described above.

In the power semiconductor unit 51A, the metal block 1A is configured by a metallic material of high electric conductivity and thermal conductivity, such as copper, into a thickness of approximately 1.0 to 5.0 mm to obtain high heat capacity and excellent heat dissipation performance.

As with the power converter 100, in the power converter 100A a ceramic material is formed directly on the upper surface 7a of the cooling heat sink 7 into a heat dissipation insulating layer 2A, the ceramic material being, for example, aluminum oxide, silicon nitride, aluminum nitride, boron nitride, or other ceramic materials of excellent thermal conductivity. It is preferred that the insulating layer 2A have a thermal conductivity of 1 to 200 W/m·K and a thickness of 10 to 500 µm.

As with the power converter 100, in the power converter 100A the lower surface 1Aa of the metal block 1A of high heat capacity and excellent heat dissipation performance on which the power semiconductor element 4 is mounted is brought into direct contact with the cooling heat sink 7, with the heat dissipation insulating layer 2A made of a ceramic material of excellent thermal conductivity therebetween. Such a power converter, therefore, has a sufficiently low thermal resistance at a lower part of the power semiconductor element 4 and excellent heat dissipation performance.

Note that Fig. 4 shows the configuration example in which one power semiconductor element 4 is mounted on the metal block 1A; however, the number of power semiconductor elements 4 to be mounted on the metal block 1A may be two, three or more. In addition, the metallic material for forming the metal block 1A is not limited to copper; thus, copper alloy, aluminum, aluminum alloy and the like, for example, are applicable as the metallic material.

In the power semiconductor unit 51A, the relay electrode insulating layer 42 formed on the upper surface 1Ab of the metal block 1A is made of, for example, aluminum oxide, silicon nitride, aluminum nitride, boron nitride, or other ceramic materials of excellent thermal conductivity. It is preferred that the relay electrode insulating layer 42 have a thermal conductivity of 1 to 200 W/m·K and a thickness of 10 to 500 µm.

The relay electrode 41 formed on the upper surface of the relay electrode insulating layer 42 is made of a metallic material of excellent thermal conductivity, such as copper. Note that the metallic material for forming the relay electrode 41 is not limited to copper; thus, copper alloy, aluminum, aluminum alloy and the like, for example, are applicable as the metallic material.

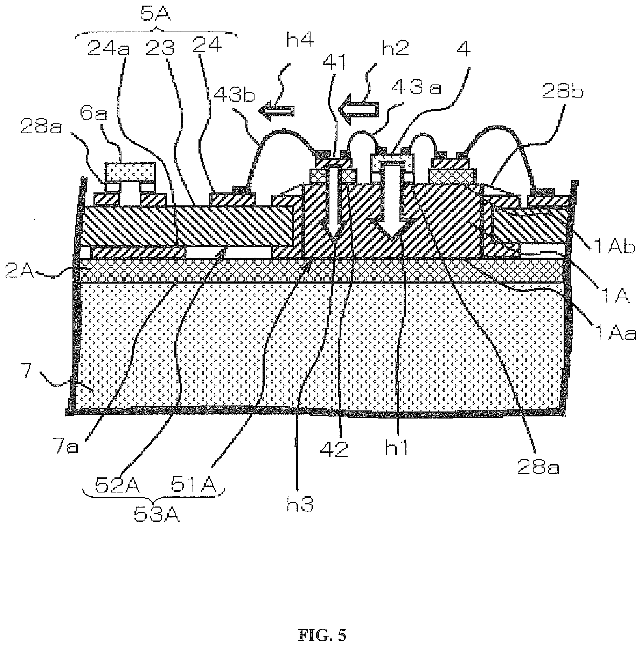

Fig. 5 is a diagram schematically showing a flow of heat in the power converter according to the second embodiment of the present invention, showing the cross-sectional structure of a part of the power converter 100A shown in Fig. 4. In Fig. 5, the power semiconductor unit 51A is placed in such a manner that the lower surface 1Aa of the metal block 1A comes into abutment against the upper surface 7a of the cooling heat sink 7, with the heat dissipation insulating layer 2A therebetween, and the relay electrode 41 is connected to the circuit pattern 24 on the upper surface 501 of the printed wiring board 5A by the bonding wire 43b. In a configuration where an IGBT, for example, is mounted as the power semiconductor element 4 in the power semiconductor unit 51A, the collector electrode on the rear surface of the IGBT is bonded to the upper surface 1Ab of the metal block 1A by soldering 28a, while the emitter electrode and the gate electrode formed on the front surface of the IGBT are connected to the relay electrode 41 by the bonding wires 43a.

In Fig. 5, the white arrows h1 to h4 schematically illustrate the flows of heat generated during operation of the power semiconductor element 4 in the power semiconductor unit 51A. The widths of the white arrows h1 to h4 qualitatively indicate the degrees of the amount of flowing heat. Note that Fig. 5 only shows the heat flowing from the power semiconductor element 4 along the left bonding wire 43a.

As shown in Fig. 5, the heat that is generated during operation of the power semiconductor element 4 in the power semiconductor unit 51A is transmitted from the power semiconductor element 4 to the cooling heat sink 7 through the solder layer 28a, the metal block 1A, and the heat dissipation insulating layer 2A, as well as to the circuit pattern 24 on the upper surface 501 of the printed wiring board 5A from the power semiconductor element 4 through the bonding wire 43a. The power converter 100A, however, has the relay electrode 41 that is formed on the metal block 1A with the relay electrode insulating layer 42 therebetween, the bonding wire 43a extending from the power semiconductor element 4 and bonded to the relay electrode 41, and the other bonding wire 43b extending from the relay electrode 41 and connected to the circuit pattern 24 on the upper surface 501 of the printed wiring board 5A. Therefore, in the power converter 100A, most of the heat flowing from the power semiconductor element 4 through the bonding wire 43a is transmitted to the cooling heat sink 7 through the relay electrode 41, the relay electrode insulating layer 42 made of a ceramic material of excellent thermal conductivity and the metal block 1A, sufficiently minimizing the amount of heat that is transmitted from the relay electrode 41 to the circuit pattern 24 of the printed wiring board 5A through the bonding wire 43b. Consequently, the amount of heat transmitted to the printed wiring board unit 52A side can be reduced, effectively preventing the printed wiring board 5A, the electronic circuit components 6a and the like configuring the printed wiring board unit 52A from being heated up.

In addition, in this power converter 100A, the heat that is generated during operation of the power semiconductor element 4 can efficiently be transmitted to the metal block 1A through two heat transmission paths: a first heat transmission path of the power semiconductor element 4 → the solder layer 28a → the metal block 1A, and a second heat transmission path of the power semiconductor element 4 → the bonding wire 43a → the relay electrode 41 → the relay electrode insulating layer 42 → the metal block 1A, as shown in Fig. 5. Thus, the functions of the metal block 1A of high heat capacity and excellent heat dissipation performance can effectively be utilized.

In the power converter according to the second embodiment of the present invention, of the heat that is generated during operation of the power semiconductor element of the power semiconductor unit, the heat that is transmitted to the printed wiring board unit connected to the power semiconductor unit can be reduced in amount, and the printed wiring board and the like can effectively be prevented from heating up, improving the heat dissipation performance of the power converter.

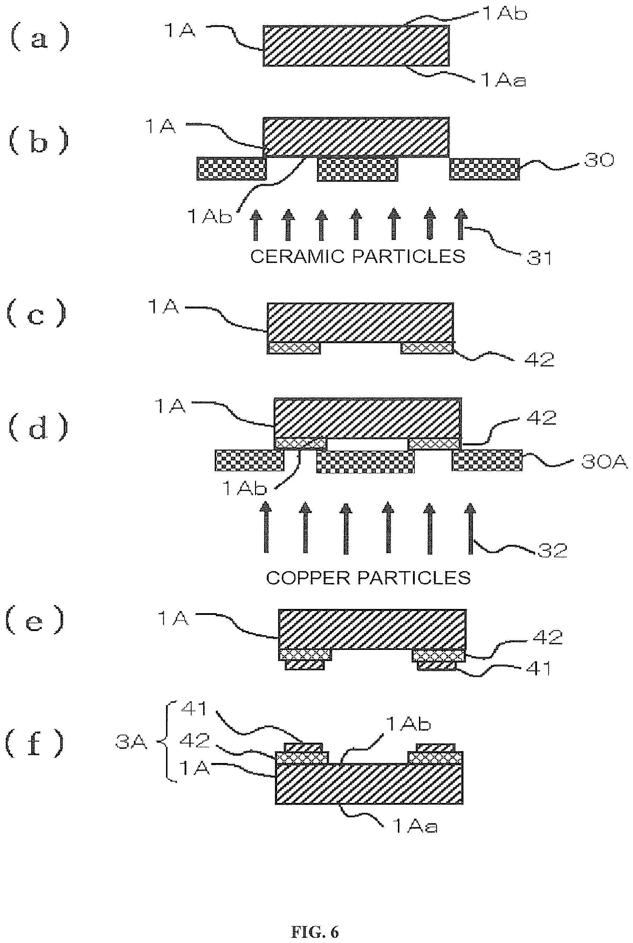

Next, a method for manufacturing the power converter according to the second embodiment of the present invention is described with reference to Figs. 6 to 8. Figs. 6 to 8 are cross-sectional diagrams each showing the method for manufacturing the power converter according to the second embodiment of the present invention.

First of all, a copper plate with a thickness of approximately 1.0 to 5.0 mm is stamped into a square or a rectangle to create a metal block 1A (Fig. 6(a)).

Next, with a mask 30 being applied to the upper surface 1Ab of the metal block 1A, ceramic powder 31 such as aluminum oxide powder is deposited thereto by means of a thermal spraying method or an aerosol deposition method, to form the relay electrode insulating layer 42 on the upper surface 1Ab of the metal block 1A (Figs. 6(b) and 6(c)). The relay electrode insulating layer 42 is formed on a part of the upper surface 1Ab of the metal block 1A instead of on the entire upper surface 1Ab. The method for forming the relay electrode insulating layer 42 using the thermal spraying method and the aerosol deposition method is the same as the method for forming the heat dissipation insulating layer 2 described with reference to Figs. 2(e) to 3(a), except that the insulating layer is formed on the upper surface 1Ab of the metal block 1A and that the mask 30 is used. Furthermore, the material of the ceramic fine particles used for forming the relay electrode insulating layer 42 using the thermal spraying method and the aerosol deposition method is the same as that used in the heat dissipation insulating layer 2 described with reference to Figs. 2(e) to 3(a). In the case where the thermal spraying method is used for forming the relay electrode insulating layer 42, it is preferable to use a plasma spraying method; however, the thermal spraying method is not limited thereto.

The thickness of the relay electrode insulating layer 42 formed by either the thermal spraying method or the aerosol deposition method is preferably 10 to 500 µm, as described above.

Next, the relay electrode 41 made of copper is stacked on the relay electrode insulating layer 42. The plasma spraying method that is used in the formation of the heat dissipation insulating layer is used as a method for depositing copper. In other words, with a mask 30A being applied to the relay electrode insulating layer 42 formed on the upper surface 1Ab of the metal block 1A, copper particles 32 are thermally sprayed thereto, thereby forming the relay electrode 41 (Figs. 6(d) and 6(e)).

Such a procedure completes a metal block 3A with a relay electrode in which the relay electrode 41 is formed on a part of the upper surface 1Ab of the metal block 1A, with the relay electrode insulating layer 42 therebetween (Fig. 6(f)).

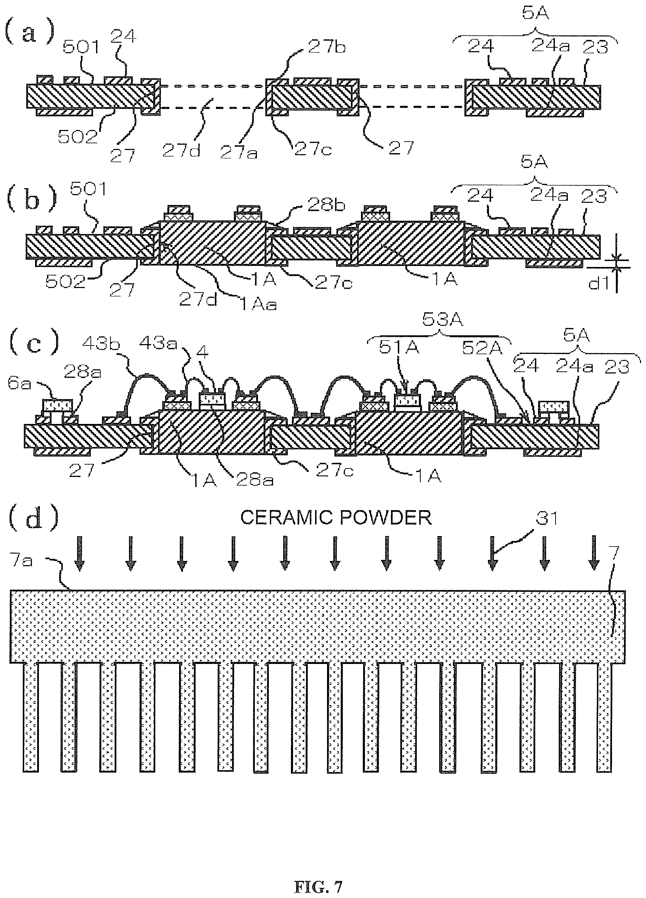

Next, as in Figs. 2(b) and 2(c) described above, the metal block 1A is inserted into the hole 27d of the through-hole portion 27 of the printed wiring board 5A and fixed to the printed wiring board 5A by soldering 28b (Figs. 7(a) and 7(b)). In so doing, an adhesive or the like may be employed together with the soldering in order to enhance the joining force between the printed wiring board 5A and the metal block 1A. As with the configuration shown in Fig. 2(c), the position of the metal block 1A in the thickness direction relative to the printed wiring board 5A is preferably adjusted such that the lower surface 1Aa of the metal block 1A is flush with the land surface of the lower surface land conductor portion 27c of the through-hole portion 27 of the printed wiring board 5A and the pattern surface of the circuit pattern 24a on the lower surface 502 of the printed wiring board 5A. In order to do so, the lower surface land conductor portion 27c and the circuit pattern 24a in the printed wiring board 5A are formed into the same thickness d1, and the distance of protrusion of the lower surface 1Aa of the metal block 1A in relation to the lower surface 502 of a substrate main body 23A of the printed wiring board 5A is also set at d1.

Next, the power semiconductor element 4 is mounted and bonded onto the metal block 1A by soldering 28a, and various electronic circuit components 6a are mounted and bonded onto the printed wiring board 5A by soldering 28a (Fig. 7(c)). These parts are mounted by soldering 28a in the same mounting method described with reference to Fig. 2(d).

Also, the power semiconductor element 4 and the relay electrode 41 are connected to each other by the bonding wire 43a (Fig. 7(c)). The bonding wire 43a is an Al wire with a wire diameter of 125 to 500 µm and is used for ultrasonically joining the power semiconductor element 4 and the relay electrode 41 together. A lead frame, for example, may also be used in place of the bonding wire 43a to connect the power semiconductor element 4 and the relay electrode 41 together.

Moreover, the relay electrode 41 and the circuit pattern 24 on the upper surface 501 of the printed wiring board 5A are connected to each other by the bonding wire 43b (Fig. 7(c)). As with the bonding wire 43a, the bonding wire 43b is an Al wire with a wire diameter of 125 to 500 µm and is used for ultrasonically joining the relay electrode 41 and the circuit pattern 24 together. A lead frame or a ribbon-shaped aluminum wire may also be used in place of the bonding wire 43b to connect the relay electrode 41 and the circuit pattern 24 of the printed wiring board 5A to each other.

Subsequently, the ceramic powder 31 is deposited by means of the thermal spraying method or the aerosol deposition method, to form the heat dissipation insulating layer 2A on the upper surface 7a of the cooling heat sink 7 (Figs. 7(d) to 8(a)). The material of the ceramic find particles for forming the heat dissipation insulating layer 2A and the method for forming the insulating layer using the thermal spraying method and the aerosol deposition method are the same as those used for forming the heat dissipation insulating layer 2 described with reference to Figs. 2(e) to 3(a).

It is preferred that the thickness of the heat dissipation insulating layer 2A formed by either the thermal spraying method or the aerosol deposition method be 10 to 500 µm, as described above. The heat dissipation insulating layer 2A formed in the manner described above has such insulation characteristics as a thickness of, for example, 200 µm and an AC breakdown voltage of 5 kV or higher, and can also be used in a power device having a withstand voltage rating of 1200 V.

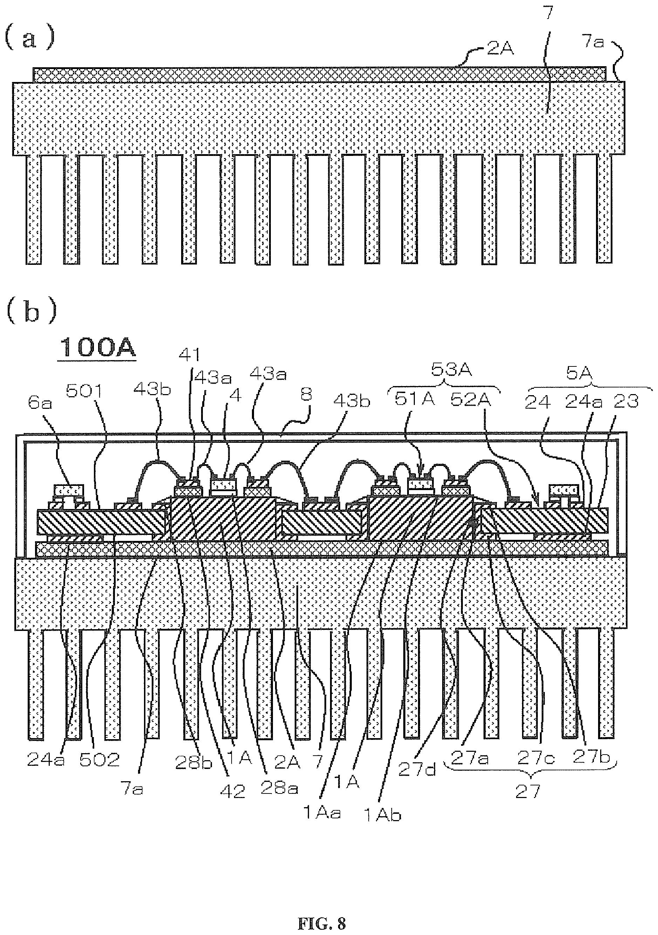

Finally, the power conversion circuit unit 53A in which the power semiconductor unit 51A and the printed wiring board unit 52A are integrated with each other is placed on the cooling heat sink 7 having the heat dissipation insulating layer 2A, with a thermal grease therebetween. The resultant structure is then covered with the case 8, completing the power converter 100A (Fig. 8(b)).

As described above, in the power converter according to the second embodiment, especially the bonding wire or lead frame extending from the power semiconductor element bonded to the upper surface (front surface) of the metal block is bonded to the relay electrode, and then the relay electrode is connected to the circuit pattern of the printed wiring board. Therefore, the heat that is generated during operation of the power semiconductor element is transmitted along the bonding wire or lead frame extending from the power semiconductor element, toward the metal block of high thermal capacity and excellent heat dissipation performance, mainly through the relay electrode and the relay electrode insulating layer made of a ceramic material of excellent thermal conductivity. As a result, the amount of heat transmitted to the circuit pattern of the printed wiring board can sufficiently be reduced.

Accordingly, the power converter according to the second embodiment of the present invention can effectively reduce the amount of heat flowing from the power semiconductor unit to the printed wiring board unit, and therefore can effectively prevent the printed wiring board and the like of the printed wiring board unit from being heated up, improving the heat dissipation performance of the power converter.

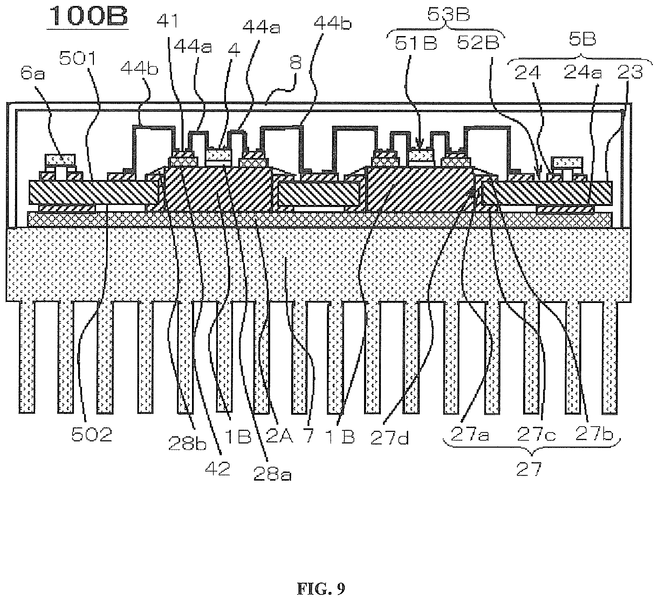

Next, Fig. 9 is a cross-sectional diagram showing a different configuration of the power converter according to the second embodiment of the present invention. The power converter 100B shown in Fig. 9 is different from the power converter 100A shown in Fig. 4 in that the power semiconductor element 4 and the relay electrode 41 are connected to each other by a lead frame 44a and that the relay electrode 41 and the circuit pattern 24 on the front surface of a printed wiring board 5B are connected to each other by a lead frame 44b. The rest of the features of the power converter 100B are the same as those of the power converter 100A.

### EXPLANATION OF REFERENCE NUMERALS

1, 1A, 1B: Metal block
1a, 1Aa: Lower surface (rear surface)
1b, 1Ab: Upper surface (front surface)
1c, 1Ac: Side surface
2, 2A: Heat dissipation insulating layer
3A: Metal block with relay electrode
4: Power semiconductor element (first circuit element)
5, 5A, 5B: Printed wiring board
6a, 6b, 6c, 6d, 6e, 6f, 6g: Electronic circuit component (second circuit element)
7: Cooling heat sink
7a: Upper surface
8: Case
9a, 9b: Printed wiring board
10: Power semiconductor module
11: Insulating substrate
12: Aluminum wire
13: Cutout portion
15: Metal base
16: Insulating layer
17: Circuit pattern
18, 18A: Connection lead terminal
19: Insulating resin
20: Case main body
21: Lid
23, 23a, 23b: Substrate main body
24, 24a, 24b, 24c: Circuit pattern
25, 25A: Supporting column
26: Wiring
27: Through-hole portion
27a: Through conductor portion
27b: Upper surface land conductor portion
27c: Lower surface land conductor portion
27d: Hole
28a, 28b: Solder
30, 30A: Mask
31: Raw material powder (ceramic powder)
32: Copper particles
41: Relay electrode
42: Relay electrode insulating layer
43a, 43b: Bonding wire
44a, 44b: Lead frame
51, 51A, 51B: Power semiconductor unit
52, 52A, 52B: Printed wiring board unit
53, 53A, 53B: Power conversion circuit assembly
100, 100A, 100B, 200: Power converter
501: Upper surface (front surface)
502: Lower surface (rear surface)

## Claims

1. A power converter (100A, 100B), comprising:
a power semiconductor unit (51, 51A, 51B) in which a first circuit element (4) configured by a power semiconductor element is mounted on an upper surface of a metal block (1, 1A) having upper and lower surfaces;
a printed wiring board unit (52, 52A, 52B) in which a second circuit element (6a, 6b, 6c, 6d, 6e, 6f, 6g) is mounted on a printed wiring board that is provided with a hole for fitting the metal block (1, 1A); and
a cooling heat sink (7),
wherein the power semiconductor unit (51, 51A, 51B) and the printed wiring board unit (52, 52A, 52B) are integrated into a power conversion circuit assembly (53, 53A, 53B) by fitting the metal block (1, 1A) to the hole,
**characterized by** comprising
a ceramic material formed directly on an upper surface of the cooling heat sink (7) to form a heat dissipation insulating layer (2, 2A), and
the power conversion circuit assembly (53, 53A, 53B) being attached to the cooling heat sink (7) in such a manner that the lower surface of the metal block (1, 1A) abuts against the upper surface of the cooling heat sink (7) with the heat dissipation insulating layer (2, 2A) therebetween,
wherein the power semiconductor unit (51, 51A, 51B) has:
a relay electrode insulating layer (42) formed by directly depositing a ceramic material on a part of the upper surface of the metal block (1, 1A); and
a relay electrode (41) formed by depositing a metallic material on an upper surface of the relay electrode insulating layer (42),
a bonding wire or a lead frame from the first circuit element (4) is joined to the relay electrode (41), and
the relay electrode (41) and a circuit pattern portion on the upper surface side of the printed wiring board (52, 52A, 52B) are connected to each other.

2. The power converter according to claim 1, wherein
the hole (27d) is an opening of a through-hole portion (27) configured by a conductor layer,
the metal block (1, 1A) is fixed to the through-hole portion by soldering,
the heat dissipation insulating layer (2, 2A) on the upper surface of the cooling heat sink (7) is configured to include a region abutting against the lower surface of the metal block (1, 1A) and a region abutting against a land surface of the through-hole portion (27).

3. The power converter according to claim 2, wherein
a conductor pattern portion is formed on a lower surface side of the printed wiring board, and
the heat dissipation insulating layer (2, 2A) on the upper surface of the cooling heat sink (7) is configured to include a region abutting against the lower surface of the metal block (1, 1A), a region abutting against a land surface of the through-hole portion (27), and a region abutting against a pattern surface of the conductor pattern portion.

4. The power converter according to claim 1, wherein the relay electrode (41) is formed by thermally spraying copper particles as the metallic material.

5. The power converter according to claim 1, wherein the relay electrode (41) and the circuit pattern portion on the upper surface side of the printed wiring board are connected to each other by the bonding wire or the lead frame.

6. The power converter according to claim 1, wherein the heat dissipation insulating layer (2, 2A) and/or the relay electrode insulating layer (42) has a thermal conductivity of 1 to 200 W/m·K and a thickness of 10 to 500 µm.

7. The power converter according to claim 1, wherein the heat dissipation insulating layer (2, 2A) and/or the relay electrode insulating layer (42) is configured by at least one type selected from a group of fillers consisting of silicon oxide, aluminum oxide, silicon nitride, aluminum nitride, and boron nitride.

8. The power converter according to claim 7, wherein the heat dissipation insulating layer (2, 2A) and/or the relay electrode insulating layer (42) is formed by plasma spray deposition of ceramic fine particles of at least one type selected from the group of fillers.

9. The power converter according to claim 7, wherein the heat dissipation insulating layer (2, 2A) and/or the relay electrode insulating layer (42) is formed by aerosol deposition of ceramic fine particles of at least one type selected from the group of fillers.

## Patentansprüche

1. Stromwandler (100A, 100B), Folgendes umfassend:
eine Leistungshalbleitereinheit (51, 51A, 51B), in welcher ein erstes Schaltungselement (4), welches durch ein Leistungshalbleiterelement eingerichtet ist, auf einer oberen Oberfläche eines Metallblocks (1, 1A) befestigt ist, welcher eine obere und eine untere Oberfläche aufweist;
eine gedruckte Schaltungsplatineneinheit (52, 52A, 52B), in welcher ein zweites Schaltungselement (6a, 6b, 6c, 6d, 6e, 6f, 6g) auf einer gedruckten Schaltungsplatine befestigt ist, welche mit einer Öffnung zum Einpassen des Metallblocks (1, 1A) versehen ist; und
einen Kühlkörper (7),
wobei die Leistungshalbleitereinheit (51, 51A, 51B) und die gedruckte Schaltungsplatineneinheit (52, 52A, 52B) durch Einpassen des Metallblocks (1, 1A) in die Öffnung in eine Stromwandlungs-Schaltungsanordnung (53, 53A, 53B) integriert sind,
**dadurch gekennzeichnet, dass** er Folgendes umfasst ein Keramikmaterial, welches unmittelbar auf einer oberen Oberfläche des Kühlkörpers (7) ausgebildet ist, um eine Wärmeabgabe-Isolierschicht (2, 2A) auszubilden, und
wobei die Stromwandlungs-Schaltungsanordnung (53, 53A, 53B) auf eine derartige Weise an dem Kühlkörper (7) befestigt ist, dass die untere Oberfläche des Metallblocks (1, 1A) an die obere Oberfläche des Kühlkörpers (7) mit der Wärmeabgabe-Isolierschicht (2, 2A) dazwischen angrenzt,
wobei die Leistungshalbleitereinheit (51, 51A, 51B) Folgendes aufweist:
eine Relaiselektroden-Isolierschicht (42), welche durch unmittelbares Abscheiden eines Keramikmaterials auf einem Teil der oberen Oberfläche des Metallblocks (1, 1A) ausgebildet ist; und
eine Relaiselektrode (41), welche durch Abscheiden eines metallischen Materials auf einer oberen Oberfläche der Relaiselektroden-Isolierschicht (42) ausgebildet ist,
wobei ein Verbindungsdraht oder ein Leiterrahmen aus dem ersten Schaltungselement (4) mit der Relaiselektrode (41) verbunden ist und
die Relaiselektrode (41) und ein Schaltungsstrukturabschnitt auf der oberen Oberflächenseite der gedruckten Schaltungsplatine (52, 52A, 52B) miteinander verbunden sind.

2. Stromwandler nach Anspruch 1, wobei
die Öffnung (27d) eine Öffnung eines Durchgangsabschnitts (27) ist, welcher durch eine Leiterschicht eingerichtet ist, der Metallblock (1, 1A) durch Löten an dem Durchgangsabschnitt befestigt ist,
die Wärmeabgabe-Isolierschicht (2, 2A) auf der oberen Oberfläche des Kühlkörpers (7) eingerichtet ist, um einen Bereich, welcher an die untere Oberfläche des Metallblocks (1, 1A) angrenzt, und einen Bereich zu umfassen, welcher an eine Anschlussoberfläche des Durchgangsabschnitts (27) angrenzt.

3. Stromwandler nach Anspruch 2, wobei
ein Leiterstrukturabschnitt auf einer unteren Oberflächenseite der gedruckten Schaltungsplatine ausgebildet ist, und
die Wärmeabgabe-Isolierschicht (2, 2A) auf der oberen Oberfläche des Kühlkörpers (7) eingerichtet ist, um einen Bereich, welcher an die untere Oberfläche des Metallblocks (1, 1A) angrenzt, einen Bereich, welcher an eine Anschlussoberfläche des Durchgangsabschnitts (27) angrenzt, und einen Bereich zu umfassen, welcher an eine Strukturoberfläche des Leiterstrukturabschnitts angrenzt.

4. Stromwandler nach Anspruch 1, wobei die Relaiselektrode (41) durch thermisches Aufsprühen von Kupferteilchen als das metallische Material ausgebildet ist.

5. Stromwandler nach Anspruch 1, wobei die Relaiselektrode (41) und der Schaltungsstrukturabschnitt auf der oberen Oberflächenseite der gedruckten Schaltungsplatine durch den Verbindungsdraht oder den Leiterrahmen miteinander verbunden sind.

6. Stromwandler nach Anspruch 1, wobei die Wärmeabgabe-Isolierschicht (2, 2A) und/oder die Relaiselektroden-Isolierschicht (42) eine Wärmeleitfähigkeit von 1 bis 200 W/m·K und eine Dicke von 10 bis 500 µm aufweist.

7. Stromwandler nach Anspruch 1, wobei die Wärmeabgabe-Isolierschicht (2, 2A) und/oder die Relaiselektroden-Isolierschicht (42) durch mindestens einen Typ eingerichtet ist, welcher aus einer Gruppe von Füllmitteln ausgewählt ist, welche aus Siliziumoxid, Aluminiumoxid, Siliziumnitrid, Aluminiumnitrid und Bornitrid besteht.

8. Stromwandler nach Anspruch 7, wobei die Wärmeabgabe-Isolierschicht (2, 2A) und/oder die Relaiselektroden-Isolierschicht (42) durch Plasmaaufsprühen feiner Keramikteilchen mindestens eines Typs ausgebildet ist, welcher aus der Gruppe von Füllmitteln ausgewählt ist.

9. Stromwandler nach Anspruch 7, wobei die Wärmeabgabe-Isolierschicht (2, 2A) und/oder die Relaiselektroden-Isolierschicht (42) durch Aerosolabscheidung feiner Keramikteilchen mindestens eines Typs ausgebildet ist, welcher aus der Gruppe von Füllmitteln ausgewählt ist.

## Revendications

1. Convertisseur de puissance (100A, 100B), comprenant :
une unité semi-conductrice de puissance (51, 51A, 51B) dans laquelle un premier élément de circuit (4) configuré par un élément semi-conducteur de puissance est monté sur une surface supérieure d'un bloc de métal (1, 1A) ayant des surfaces supérieure et inférieure ;
une unité de carte de circuit imprimé (52, 52A, 52B) dans laquelle un second élément de circuit (6a, 6b, 6c, 6d, 6e, 6f, 6g) est monté sur une carte de circuit imprimé qui est dotée d'un trou pour s'ajuster au bloc de métal (1, 1A) ; et
un dissipateur thermique de refroidissement (7),
dans lequel l'unité semi-conductrice de puissance (51, 51A, 51B) et l'unité de carte de circuit imprimé (52, 52A, 52B) sont intégrées dans un ensemble de circuit de conversion de puissance (53, 53A, 53B) en ajustant le bloc de métal dans le trou,
**caractérisé en ce qu'**il comprend
un matériau céramique formé directement sur une surface supérieure du dissipateur thermique de refroidissement (7) pour former une couche isolante de dissipation thermique (2, 2A), et
l'ensemble circuit de conversion de puissance (53, 53A, 53B) étant fixé au dissipateur thermique de refroidissement (7) de telle manière que la surface inférieure du bloc de métal (1, 1A) vient en butée contre la surface supérieure du dissipateur thermique de refroidissement (7) avec la couche isolante de dissipation thermique (2, 2A) entre elles,
dans lequel l'unité semi-conductrice de puissance (51, 51A, 51B) possède :
une couche isolante d'électrode de relais (42) formée en déposant directement un matériau céramique sur une partie de la surface supérieure du bloc de métal (1, 1A) ; et
une électrode de relais (41) formée en déposant un matériau métallique sur une surface supérieure de la couche isolante d'électrode de relais (42),
un fil de connexion ou une grille de connexion du premier élément de circuit (4) est reliée à l'électrode de relais (41), et
l'électrode de relais (41) et une partie de tracé du circuit sur le côté surface supérieure de la carte de circuit imprimé (52, 52A, 52B) sont connectées l'une à l'autre.

2. Convertisseur de puissance selon la revendication 1, dans lequel
le trou (27d) est une ouverture d'une partie de trou traversant (27) configurée par une couche conductrice,
le bloc de métal (1, 1A) est fixé à la partie de trou traversant par brasage,
la couche isolante de dissipation thermique (2, 2A) sur la surface supérieure du dissipateur thermique de refroidissement (7) est configurée de manière à inclure une région venant en butée contre la surface inférieure du bloc de métal (1, 1A) et une région venant en butée contre une surface d'appui de la partie de trou traversant (27).

3. Convertisseur de puissance selon la revendication 2, dans lequel
une partie de tracé conducteur est formée sur un côté surface inférieure de la carte de circuit imprimé, et
la couche isolante de dissipation thermique (2, 2A) sur la surface supérieure du dissipateur thermique de refroidissement (7) est configurée de manière à inclure une région venant en butée contre la surface inférieure du bloc de métal (1, 1A), une région venant en butée contre une surface d'appui de la partie de trou traversant (27) et une région venant en butée contre une surface de tracé de la partie de tracé conducteur.

4. Convertisseur de puissance selon la revendication 1, dans lequel l'électrode de relais (41) est formée en pulvérisant thermiquement des particules de cuivre en tant que matériau métallique.

5. Convertisseur de puissance selon la revendication 1, dans lequel l'électrode de relais (41) et la partie de tracé du circuit sur le côté surface supérieure de la carte de circuit imprimé sont connectées l'une à l'autre par le fil de connexion ou la grille de connexion.

6. Convertisseur de puissance selon la revendication 1, dans lequel la couche isolante de dissipation thermique (2, 2A) et/ou la couche isolante d'électrode de relais (42) a une conductivité thermique de 1 à 200 W/m·K et une épaisseur de 10 à 500 µm.

7. Convertisseur de puissance selon la revendication 1, dans lequel la couche isolante de dissipation thermique (2, 2A) et/ou la couche isolante d'électrode de relais (42) est configurée par au moins un type choisi dans un groupe de charges constituées d'oxyde de silicium, d'oxyde d'aluminium, de nitrure de silicium, de nitrure d'aluminium et de nitrure de bore.

8. Convertisseur de puissance selon la revendication 7, dans lequel la couche isolante de dissipation thermique (2, 2A) et/ou la couche isolante d'électrode de relais (42) est formée par dépôt par projection de plasma de fines particules de céramique d'au moins un type choisi dans le groupe de charges.

9. Convertisseur de puissance selon la revendication 7, dans lequel la couche isolante de dissipation thermique (2, 2A) et/ou la couche isolante d'électrode de relais (42) est formée par dépôt par aérosol de fines particules de céramique d'au moins un type choisi dans le groupe de charges.
